Europäisches Patentamt

European Patent Office

Office européen des brevets

(11) Publication number: **0 141 496**
**A1**

## (12) EUROPEAN PATENT APPLICATION

(21) Application number: **84305625.0**

(22) Date of filing: **17.08.84**

(51) Int. Cl.⁴: **H 01 L 21/316**

(30) Priority: **31.08.83 US 528344**

(43) Date of publication of application:
**15.05.85 Bulletin 85/20**

(84) Designated Contracting States:
**AT BE CH DE FR GB IT LI NL SE**

(71) Applicant: **MORTON THIOKOL, INC.**
**110 North Wacker Drive**
**Chicago, Illinois 60606(US)**

(72) Inventor: **Gagnon, Richard J.**
**RED 1**
**Woodstock Vermont 05091(US)**

(74) Representative: **Warren, Keith Stanley et al,**
**BARON & WARREN 18 South End Kensington**
**London W8 5BU(GB)**

(54) **Process for deposition silicon dioxide containing dopant onto a substrate.**

(57) A process for depositing a silicon dioxide glass containing a known amount of dopant onto a plurality of sequential batches of substrates from a liquid mixture using low pressure chemical vapor deposition. The liquid mixture contains a tetraalkyl orthosilicate, and a dopant source compound which is a trialkyl borate, phosphite, arsenate, or antimonate. The dopant source compound and tetraalkyl orthosilicate in the liquid mixture are chosen to provide substantially equal vaporization of tetraalkyl orthosilicate and dopant source compound.

EP 0 141 496 A1

Croydon Printing Company Ltd.

"PROCESS FOR DEPOSITING SILICON DIOXIDE CONTAINING DOPANT ONTO A SUBSTRATE"

0141496

The present invention relates to the doping of semiconductors, and more particularly, a process for depositing a dopant containing glass on the surface of a substrate.

The production of electronic products such as semiconductor elements or monolithic circuits necessarily involve the doping of an appropriate substrate with either an n-type or p-type dopant. Various processes are known for depositing dopant containing glasses or films.

Currently, most doping on a commercial scale is being performed using extremely toxic and hazardous gases such as phosphine or diborane in combination with silane and oxygen. These gases must be stored in special closets and require the use of special safety valves. The resulting safety apparatus is large and cumbersome.

An alternative to the use of such gases has been the use of liquids which are transported from a bubbler by entrainment in an inert carrier gas. A carrier gas such as nitrogen which is inert to the dopant source compound is introduced through an inlet valve and dip tube to the bottom of the cartridge of the bubbler under atmospheric pressure. In bubbling up through the dopant source compound, molecules of the compound intermingle with those of the gas. The gas, saturated with the vapor of the dopant source compound, is pressured through an outlet valve where it is delivered to the deposition system. Other bubblers may be hooked up in either series or parallel.

0141496

Numerous patents and papers discuss the doping of semiconductors. Those items related to liquid mixture dopants include U.S. Patent 3,281,291, which discloses a method of fabricating a semiconductor junction device which includes the deposition of a silicon dioxide layer on the surface of a crystalline semiconductor wafer by vapor phase deposition at atmospheric pressure. The liquid used for deposition is a mixture of an organic siloxane compound and a suitable dopant source compound for the particular semiconductor. Examples of dopant source compounds therein are trimethyl borate, triethyl borate, and trimethyl phosphate. Examples of the siloxane compounds are ethyl silicate (also referred to as tetraethyl orthosilicate) and ethyl triethoxysilane. The '291 patent states that the proportions of siloxane compound and dopant source compound may be varied to obtain different concentrations of the doping agent in the deposited silicon dioxide layers and that to increase the amount of doping agent deposited on the surface of the substrate, the amount of dopant source compound in the liquid mixture must be increased.

An alternative to the dopant source compound solutions disclosed in the '291 patent are those disclosed in U.S. Patent 3,459,668. The '668 patent discloses the use of mixtures of trimethyl borate and methanol, or of trimethyl phosphate and methanol, at atmospheric pressure. Again it is stated that the surface concentration in atoms/cc increases as the mole percent of trimethyl borate or trimethyl phosphate in the methanol increases.

U.S. Patent 3,492,175 is another example of an atmospheric deposition system in which a carrier gas is used to carry an organometallic compound to a reactor for decomposition and thus deposit of a dopant onto a substrate.

Other liquid dopant sources include boron tribromide and phosphorus oxychloride. However, these sources are not only quite toxic and corrosive, thus requiring extreme care in handling, but they also tend to clog the valves and dip tubes of a bubbler apparatus.

As an alternative to vapor phase doping from similar liquids, the prior art has suggested the use of compounds which are applied to the substrate directly as liquids, referred to as "spin-on" processes. U.S. Patents 3,789,023 and 4,236,948 are typical of such spin-on processes where the dopant is deposited as a liquid onto a substrate as a portion of a liquid mixture. Typical sources of silicon for use in such solutions are compounds such as tetraethyl orthosilicate in admixture with a dopant source compound such as an oxide or chloride. However, "spin-on" processes require large amounts of materials and labor, as well as a suitable intermediate binding material so that the dopant source compound adheres to the substrate.

The liquid diffusion sources referred to above have been suggested as a replacement for the gaseous sources since the early days of the semiconductor industry. However, these early suggestions have met with mixed success because of the problems of surface damage during deposition, non-uniformity of films, limited shelf life of chemicals, and other such problems. Commercially, doping from gaseous sources has been almost exclusively used, even though it can be hazardous due to the nature of the gases used, the longer time cycles and extra heat treatment steps required, and the large capital cost outlay investment for safety equipment required. While it has been theoretically apparent that a liquid dopant source compound would provide more reproducibility, more economy, and higher yields than gaseous dopant sources, the major problem has been the difficulty of achieving low sheet resistance without creating a great number of surface defects.

All of the above has recently led to renewed interest in the use of liquid sources for depositing silicon dioxide glass films. In particular, "The Step Coverage of CVD $SiO_2$ Glass Films", Materials Letters, June 1982, Volume 1, No. 1, pages 29-32, describes the advantages for deposition of undoped silicon dioxide glass films using tetraethyl orthosilicate at partial pressures between 0.13 and 0.70 torr. Similar discussion and research appears in a paper entitled "Low Pressure Deposition of Phosphosilicate Glass Films", Journal of the Electrochemical Society, Volume 129, No. 7, July 1982, pages 1588-1591, where phosphosilicate glass films were deposited on silicon substrates by the reaction of tetraethyl orthosilicate, phosphine and oxygen. However, this particular combination still suffers because of the hazards of the prior art since phosphine gas is used.

Accordingly, a need exists for a simple but reliable process for depositing dopant containing glass films without the use of doping materials such as phosphine or diborane gases with their concomitant disadvantages.

The present invention is a process for depositing a silicon dioxide glass containing a known amount of dopant onto a plurality of sequential batches of substrates from a liquid mixture using low pressure chemical vapor deposition. The liquid mixture contains a tetraalkyl orthosilicate, and a dopant source compound which is a trialkyl borate, phosphite, arsenate, or antimonate. The dopant source compound and tetraalkyl orthosilicate in the liquid mixture are chosen to provide substantially equal vaporization of tetraalkyl orthosilicate and dopant source compound.

The doping mixture of the present invention utilizes relatively safe compounds in contrast to the chemicals presently used for low pressure chemical vapor deposition (LPCVD) such as silane, diborane, phosphine, boron tribromide, and phosphorus oxychloride.

## BRIEF DESCRIPTION OF THE DRAWINGS

Fig. 1 is a graph illustrating the sheet resistance of a silicon wafer after deposition from a solution of 25% by volume of trimethyl borate in tetraethyl orthosilicate, and after subsequent treatments.

Fig. 2 is a graph illustrating the sheet resistance of a silicon wafer after deposition from a solution of 9.1% by volume of trimethyl borate in tetraethyl orthosilicate, and after subsequent treatments.

Fig. 3 is a graph illustrating the sheet resistance of a silicon wafer after deposition from a solution of 3.2% by volume of trimethyl borate in tetraethyl orthosilicate, and after subsequent treatments.

The liquid chemical doping mixture used in the present invention includes two compounds. The first compound is the dopant source compound which is a $C_1$ to $C_4$ trialkyl phosphite, borate, arsenate, or antimonate, preferably trimethyl or triethyl phosphite, or triethyl or tripropyl borate. If desired, mixtures of compounds of various chain length may be used.

The other compound of the liquid chemical doping mixture is a silicon containing compound which decomposes to deposit the silicon dioxide film. This silicon containing compound is a tetraalkyl orthosilicate in which each alkyl has one to three carbon atoms, preferred compounds being tetramethyl orthosilicate (TMOS) and tetraethyl orthosilicate (TEOS). Mixtures of various chain length orthosilicates can also be used if desired.

The dopant source compound and silicate must be chosen so that they are completely miscible in the volume range over which they will be combined. In addition, there must be no reaction between the dopant source compound and silicate prior to decomposition and deposition in the reaction chamber. It is also preferred that the vapor pressures and boiling points of the dopant source compound and the silicate be as close to each other as possible. Accordingly triethyl phosphite (b.p. = 156°C) or tripropyl borate (b.p. = 175°C) are preferably used with tetraethyl orthosilicate (b.p. = 168°C), whereas trimethyl phosphite (b.p. = 112°C) or triethyl borate (b.p. = 120°C) are more preferably used with tetramethyl orthosilicate (b.p. = 122°C).

The apparatus used to practice the present invention can be any of those well-known in the art of low pressure chemical vapor deposition (LPCVD). Various bubbler cylindrical cartridge and dip tube assemblies which include inlet and outlet bellows valves are commercially available. A preferred assembly, and the one utilized in the examples below, is an all welded steel cylinder coated on its interior with Teflon® and manufactured by Alfa Products, Danvers, Mass.

The apparatus may include a two-way valve to allow deposition utilizing either the vapor from the mixture in the bubbler alone, or in the alternative, the vapor from the mixture may be mixed with a carrier gas which is inert to the mixture.

The carrier gas must be inert to the doping agent and is typically nitrogen, argon, helium or mixtures thereof. The use of a carrier gas is optional. If desired, the vapor pressures of the dopant source compound and silicate allow the process to be performed relying entirely upon the vacuum in the apparatus for vaporization without the use of a carrier gas. Extremely rapid deposition is obtained when no carrier gas is used, which is a considerable advantage when thick layers are sought.

The deposition chamber can be any of those well-known in the art. The wafers onto which the dopant containing silicon dioxide glass will be deposited are loaded vertically in the chamber with the spacing between wafers being about 1/2 inch, and as many wafers as desired being positioned therein, often as many as 350. The chamber is heated by resistance or radio frequency heating to between about 725 to 875°C. The bubbler chamber is continually chilled with water to maintain a constant temperature of about 27-29°C. The pressure within the system is maintained between about 0.1 and about 1.0 torr, preferably about 0.6 torr in the case of phosphite dopants and about 0.8 torr in the case of borate dopants.

The dopant source compound is incorporated in the bubbler mixture at between about 0.01% and about 40% by volume, preferably between about 0.04 and about 3.0% by volume.

A typical treatment subsequent to deposition of the dopant containing glass is to heat the wafer at an increased temperature for a certain period of time to transfer the dopant from the glass to the wafer, sometimes referred to as a "soak". After soaking, the glass layer is stripped off. If desired, an additional treatment can be used in which the temperature is increased even higher to drive the dopant at the surface of the wafer into the interior of the wafer, often referred to as "drive-in." In prior art deposition, the sheet resistance typically doubles after drive-in as compared to the measurement after soaking.

Surprisingly, using LPCVD and the liquid chemical doping mixture of the present invention, this result is not seen. In fact at lower concentrations of the dopant source compound, a reversal is actually seen in which the sheet resistance decreases after drive-in. This unexpected result allows liquid chemical doping mixtures to be used which employ very small concentrations of the dopant source compound. Moreover, when the percentage of dopant source compound in the mixture exceeds a certain amount, dopant is no longer deposited in the silicon dioxide glass film. Thus, it has surprisingly been found that acceptable sheet resistance values can be obtained even when the proportion of dopant source compound in the mixture in the bubbler is drastically decreased.

While not wishing to be bound by theory, it is believed that the deposition of dopant in the deposited glass is related to the relative vapor pressures of the dopant source compound and the silicon containing compound. For example, the vapor pressure of tetraethyl orthosilicate is 1 mm at 30°C, while the vapor pressure of trimethyl borate at 30°C is 110 mm. It is believed that if the percentage of the borate is too great, the vacuum simply pulls all of the vaporized dopant source compound past the silicon wafer substrates before a sufficient amount of silicon containing compound has deposited on the surface of the substrate.

Evidence for this theory is an analysis of the contents of the bubbler after samples containing varying amounts of trimethyl borate are used for depositing glasses in the normal manner. The four mixtures are as follows:

| Solution | TEOS*(ml) | TMB**(ml) | TMB(vol.%) |
|----------|-----------|-----------|------------|
| 1 | 50 | 5 | 9.1 |
| 2 | 30 | 10 | 25 |
| 3 | 120 | 4 | 3.2 |
| 4 | 120 | 4 | 3.2 |

*tetraethyl orthosilicate

**trimethyl borate

Each of the solutions is utilized to deposit a layer of silicon dioxide glass on wafers in the apparatus described above. A twenty minute sweep, i.e. the vacuum is applied for twenty minutes in each case, is used except for the wafers treated with solution 3 which are subjected to two twenty minute sweeps.

At the completion of the sweep or sweeps, and a subsequent heat diffusion, wafers treated with solution 2 (25 vol.% of TMB) have suffered the greatest reduction in the amount of boron dopant at the surface of the wafer, followed by the wafers treated with solution 1 (9.1 vol.%). The least change in concentration is seen in the wafers subjected to two sweeps of solution 3 (3.2 vol.%, two twenty minute sweeps), with the wafers treated with solution 4 having a boron content which changed by an amount between that of wafers treated with solution 1 and wafers treated with solution 4.

However, the lack of boron deposition is not due to a lack of contact between the trimethyl borate and the wafer substrates. An analysis of the solutions used for deposition shows that the solutions containing higher concentrations of trimethyl borate have been entirely depleted of boron source compound. In contrast, the solutions of lower concentration retain at least a portion of their original boron content.

To determine the amount of boron remaining in each solution, the solutions are diluted with methanol and then analyzed for boron content by atomic absorption spectroscopy using boric acid/methanol standard solutions. The volume percent TMB is calculated as follows:

$$\text{Vol. \% TMB} = \frac{B \times C \times 10^{-10}}{D \times E}$$

where:

B = $\mu$g/ml boron

C = TMB formula weight = 61.8 g/mole

D = density of TMB = 0.915 g/ml

E = atomic weight of boron = 10.81 g/mole

The results of the spectroscopy are as follows:

| Solution | Boron ($\mu$g/ml) | TMB (Vol.%) |
|---|---|---|
| 1 (9.1% TMB) | N.D.* | N.D. |
| 2 (25% TMB) | N.D. | N.D. |
| 3 (3.2% TMB; two sweeps) | 105 | 0.066 |
| 4 (3.2% TMB) | 2488 | 1.55 |

*N.D. - not detectable, i.e. less than 50 $\mu$g/ml of boron (0.03 vol.% TMB).

From these results, it is apparent that the trimethyl borate has been removed from the solution and thus has passed by the wafer substrates. However, it has apparently failed to deposit.

The amount of dopant source compound used will vary somewhat depending on its vapor pressure and the vapor pressure of the silicate being used. However, the necessary ratio can be determined by routine experimentation provided the relationship between dopant concentration in the glass and concentration of dopant source compound in the liquid chemical doping mixture is taken into consideration.

It is preferred that the mixtures be adjusted such that the vacuum vaporizes a mixture containing the same ratio of dopant source compound to silicon containing compound as is found in the bubbler. This allows solutions to be deposited in the bubbler and multiple sweeps or runs to be made without the need to replenish one or the other of the components. Moreover, reproducibility is enhanced since the concentration of dopant source compound does not change as a function of time.

Diffusion of dopant from the silicon dioxide into the substrate is accomplished in the same manner as the prior art, i.e. by heating to temperatures between about 900-1250°C for a period which may vary from about 15 minutes to several hours. The diffusion step is followed by etching with any of several agents well known to those skilled in the art, such as hydrofluoric acid, to remove the silicon dioxide glass which contains undiffused dopant.

In order to further illustrate the present invention and its advantages, the following specific examples are given, it being understood that these examples are intended only to be illustrative without serving as a limitation on the scope of the present invention.

## EXAMPLES 1-9

The following examples are run utilizing a deposition temperature of 750°C maintained by resistance heating. A deposition time of 20 minutes and a vacuum pressure of 0.8 torr are used. The bubbler temperature is maintained between 27 and 29°C. The deposited glass is typically in the range of about 2200 angstroms thick. Tetraethyl orthosilicate (TEOS) (vapor

0141496

-13-

pressure = 1 mm at 30°C; b.p. = 168°C) is used as the silicon dioxide glass producing material. Trimethyl borate (TMB) (vapor pressure = 110 mm at 30°C; b.p. = 68°C) is used as the source of boron. Differing amounts by volume of trimethyl borate are used, and nitrogen gas is employed as the carrier gas. The silicon dioxide glass is deposited on polished phosphorus doped substrates, 3 to 5 ohm-cm, 1-1-1 silicon wafers which are 0.015 inch thick, commonly referred to as "N" type monitors.

Table I provides the pertinent information concerning the liquid chemical doping mixture for each Example, the treatment conditions for the soak and drive-in steps, and the measured sheet resistances $\rho_S$.

TABLE I

| EX. NO. | TMB (ML)/ TEOS (ML) | VOL.% TMB | ML EVAPORATED AFTER 20 MIN. | SOAKING TIME (MIN) | SHEET RESISTANCE (OHMS/CM$^2$) | |
|---|---|---|---|---|---|---|
| | | | | | AFTER 1050°C DRY 2% $O_2$ IN DRY $N_2$ | AFTER STRIPPING GLASS AND 1250°C FOR 4.5 HOURS |
| 1 | 10/30 | 25 | 14 | 180 | 6.7 | 11.9 |
| 2 | 10/30 | 25 | 14 | 75 | 8.6 | 15.0 |
| 3 | 10/30 | 25 | 14 | 30 | 12.2 | 18.8 |
| 4 | 5/50 | 9.1 | 27 | 180 | 8.3 | 14.2 |
| 5 | 5/50 | 9.1 | 27 | 75 | 16.9 | 22.4 |
| 6 | 5/50 | 9.1 | 27 | 30 | 32.6 | 33.8 |
| 7 | 4/120 | 3.2 | 12.5 | 180 | 20.3 | 17.5 |
| 8 | 4/120 | 3.2 | 12.5 | 75 | 45.0 | 32.4 |
| 9 | 4/120 | 3.2 | 12.5 | 30 | 57.3 | 35.3 |

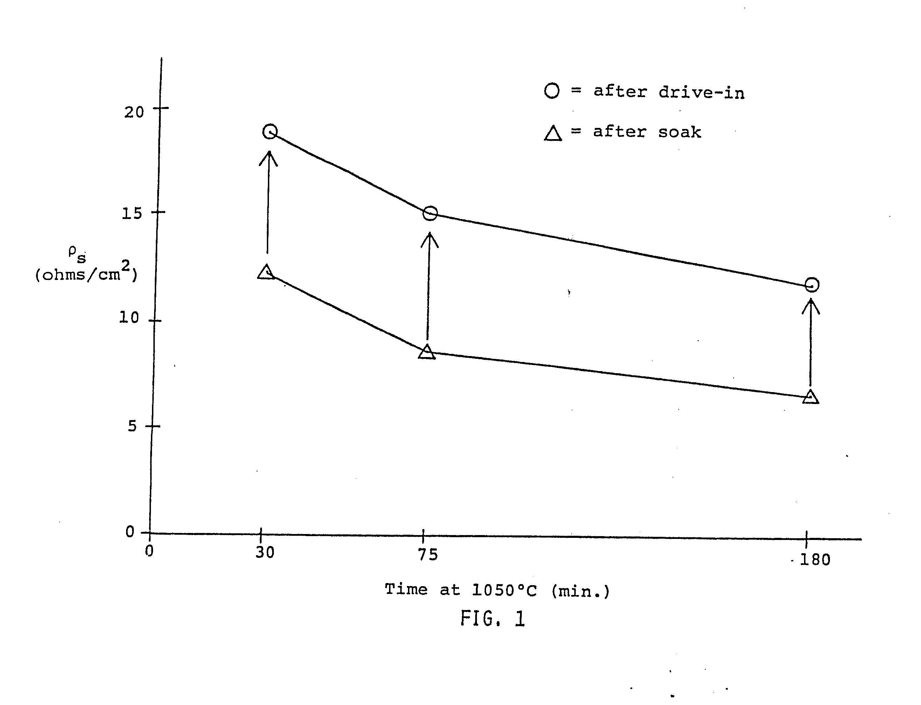

The results reported in TABLE I are illustrated graphically in Figs. 1-3.

As shown in Fig. 1, for Examples 1-3 in which the concentration of trimethyl borate is 25% by volume, little change in sheet resistance is seen when the soak time is increased from 75 minutes to 180 minutes. This sheet resistance after soaking is increased by approximately the same number of ohms/cm$^2$ by the drive-in step regardless of the soak time.

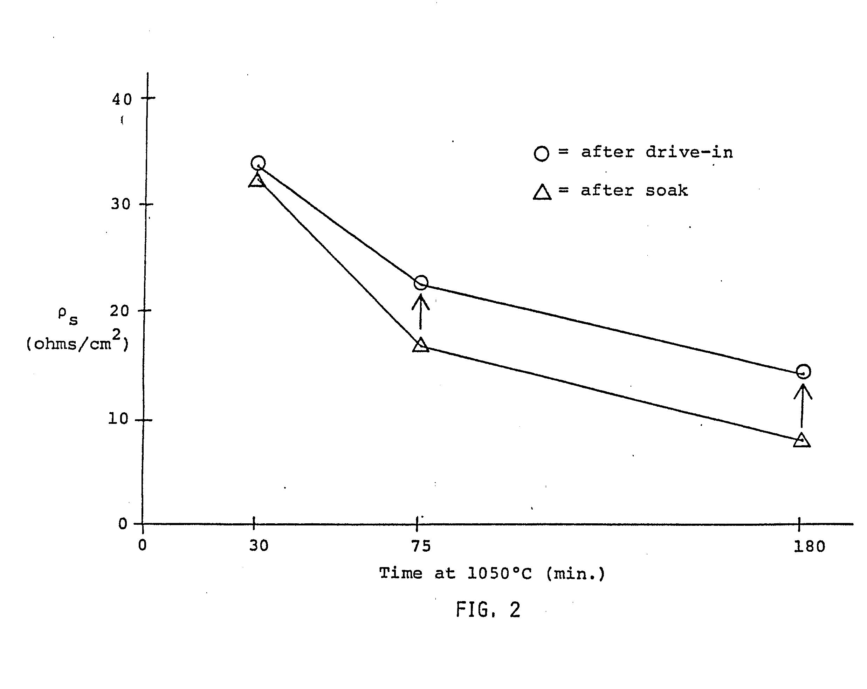

Fig. 2 illustrates the result from Examples 4-6 in which the concentration of trimethyl borate is 9.1% by volume. For this concentration, longer soaking times provide additional reductions in sheet resistance both after the soaking step and the drive-in step.

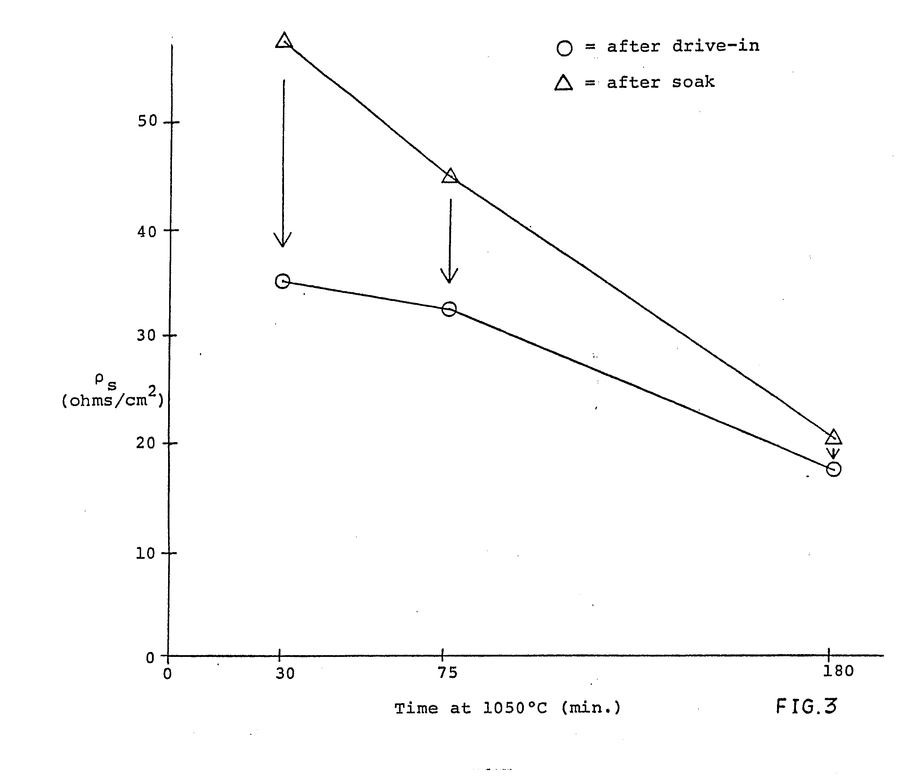

Fig. 3 illustrates the results of Examples 7-9 in which the concentration of trimethyl borate is 3.2% by volume. For this concentration, the trend is actually reversed. The drive-in step results in a decrease in the sheet resistance value (i.e., a higher concentration of boron).

### EXAMPLES 10-13

The following examples are run using the same conditions as in Examples 1-9, except that a vacuum pressure of 0.6 torr is employed. Trimethyl phosphite (TMP) (b.p. = °C) is used as the source of phosphorus, and tetraethyl orthosilicate is used as the silicon dioxide producing material. Differing amounts by volume of trimethyl phosphite are used, and nitrogen gas is employed as the carrier gas. The silicon dioxide glass is deposited on polished boron doped substrates, 3 to 5 ohm-cm, 1-1-1 silicon material, 0.014 inches thick known as "P" type monitors.

Table II provides the pertinent information concerning the liquid chemical doping mixture for each Example, the treatment conditions for the soak step, and the measured sheet resistances.

## TABLE II

| EX. NO. | TMP (ML)/ TEOS (ML) | VOL. % TMP | SOAKING TIME (MIN) | SHEET RESISTANCE (OHMS/CM$^2$) AFTER 1025°C DRY 2% $O_2$ IN DRY $N_2$ |
|---|---|---|---|---|
| 10 | 10/30 | 25% | 45 | 6.1 |
| 11 | 10/30 | 25% | 90 | 5.9 |
| 12 | 4/120 | 3.2% | 45 | 58.0 |
| 13 | 4/120 | 3.2% | 90 | 228.1 |

While the invention has been described in terms of various preferred embodiments, one skilled in the art will appreciate that various modifications, substitutions, omissions, and changes may be made without departing from the spirit thereof. Accordingly, it is intended that the scope of the present invention be limited solely by the scope of the following claims.

CLAIMS

1. A process for depositing a silicon dioxide glass containing a known amount of dopant onto a plurality of sequential batches of substrates, the depositions being by low pressure chemical vapor deposition from a liquid mixture, comprising the use of a liquid mixture containing a tetraalkyl orthosilicate, and a dopant source compound which is a trialkyl borate, phosphite, arsenate, or antimonate, the dopant source compound and tetraalkyl orthosilicate being chosen to provide substantially equal vaporization of tetraalkyl orthosilicate and dopant source compound.

2. The process of claim 1 wherein the pressure is between about 0.1 and about 1.0 torr.

3. The process of claim 1 wherein the temperature of deposition is between about 725 and about 875°C.

4. The process of claim 1 wherein the dopant source compound is present in the liquid mixture at between about 0.01 and about 40% by volume.

5. The process of claim 1 wherein the dopant source compound is present in the liquid mixture at between about 0.04 and about 3.0% by volume.

6. The process of claim 1 wherein each alkyl of the tetraalkyl orthosilicate contains one to three carbon atoms.

7. The process of claim 1 wherein the tetraalkyl orthosilicate is tetramethyl orthosilicate or tetraethyl orthosilicate.

8. The process of claim 1 wherein each alkyl of the trialkyl borate, phosphite, arsenate or antimonate contains one to four carbon atoms.

9. The process of claim 1 wherein the trialkyl borate is triethyl borate or tripropyl borate.

10. The process of claim 1 wherein the trialkyl phosphite is trimethyl phosphite or triethyl phosphite.

11. The process of claim 1 wherein the mixture contains tetraethyl orthosilicate, and either tripropyl borate or triethyl phosphite.

12. The process of claim 1 wherein the mixture contains tetramethyl orthosilicate, and either trimethyl phosphite or triethyl borate.

13. The process of claim 1 wherein a carrier gas is employed in the deposition process.

14. The process of claim 13 wherein the carrier gas is nitrogen, argon, helium or mixtures thereof.

15.   The process of claim 1 wherein the vapor is obtained exclusively from the liquid mixture in the absence of a carrier gas.

16.   The process of claim 1 wherein a trialkyl borate and a vacuum of about 0.8 torr are employed.

17.   The process of claim 1 wherein a trialkyl phosphite and a vacuum of about 0.6 torr are employed.

FIG. 1

0141496

FIG. 2

FIG.3

3/3

014496

European Patent
Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | US-A-3 476 620  (CRISHAL et al.)  *Claims 1-3* | 1,6-9, 11 | H 01 L   21/316 |
| A | FR-A-2 115 166  (INTERNATIONAL BUSINESS MACHINES)  *Claims 1,3,9,10* | 1 | |
| A | FR-A-2 123 652  (INTERNATIONAL BUSINESS MACHINES)  *Claims 1,2* | 1,8 | |
| A | US-A-4 105 810  (YAMAZAKI et al.)  *Claims 1,3,6,7,14* | 1 | |

TECHNICAL FIELDS
SEARCHED (Int. Cl.4)

H 01 L

The present search report has been drawn up for all claims

| Place of search THE HAGUE | Date of completion of the search 12-12-1984 | Examiner LIPPENS M.H. |
|---|---|---|